**Europäisches Patentamt**

**European Patent Office**

**Office européen des brevets**

(19)

(11) **EP 1 231 641 A1**

(12) **EUROPEAN PATENT APPLICATION**

(43) Date of publication:
**14.08.2002 Bulletin 2002/33**

(51) Int Cl.⁷: $H01L\ 27/146$, $H04N\ 3/15$

(21) Application number: **01810136.0**

(22) Date of filing: **09.02.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **C.S.E.M. CENTRE SUISSE D'ELECTRONIQUE ET DE MICROTECHNIQUE SA**
**2007 Neuchâtel (CH)**

(72) Inventor: **Lauxtermann Stefan**
**8965 Berikon (CH)**

(74) Representative: **Brulliard, Joel**
**c/o CSEM Centre Suisse d'Electronique et de Microtechnique SA,**
**Jaquet-Droz 1**
**2007 Neuchâtel (CH)**

(54) **Active pixel with analog storage for an opto-electronic image sensor**

(57)     The active pixel with analog storage for a semiconductor-based opto-electronic image sensor according to the invention comprises means for generating an electric photocharge as a function of incident electromagnetic radiation, and means for storing at least part of the photocharge, the storage means having a determined capacitance at a given time. The capacitance of the storage means can be varied by applying an electric signal to the storage means. The capacitance of the storage means is set to a first low value for reading out the photocharge stored in the storage means, and to a second higher value for storing the photocharge in the storage means. The pixel can, for instance, be used to realize a shutter pixel with increased sensitivity or an analog signal storage with increased sensitivity compared to prior-art pixel designs with analog storage functionality.

Fig. 4

**EP 1 231 641 A1**

**Description**

FIELD OF THE INVENTION

The invention relates to a semiconductor-based opto-electronic image sensor, and more particularly to an active photosensitive site (called pixel) with analog storage for such a sensor. The active pixel can, e.g., be used to realize the function of a global shutter. It has a high sensitivity and is therefore especially well suited for low-light and/ or high-speed applications.

BACKGROUND OF THE INVENTION

Complementary-metal-oxide-semiconductor (CMOS) active-pixel sensors (APS) have extended the application range of opto-electronic imaging. Using main-stream CMOS technology made it possible for instance to integrate on one single chip an imager with very complex functionality. This has led to the development of single-chip cameras which comprise photo-detection elements, analog-to-digital conversion, sensor control, analog and digital signal processing and many other features. Such photosensors may have an increased dynamic range or analog memory functions.

However, CMOS sensors usually have a smaller sensitivity compared to advanced charge-coupled-device (CCD) sensors, which have reached a very high performance level. Improving the sensitivity of an APS is therefore still a field of active research, and many techniques have been proposed to increase the signal swing or reduce the noise.

In the following, the background of the invention will be discussed with the idea to realize a semiconductor-based photosensor (realized, e.g., in a standard CMOS technology) with analog storage. This storage function is to be employed for sensors with a multitude of pixels, i.e., two-dimensional imagers, where the available space for electronic circuitry is limited. The possibility to store a photogenerated signal inside a pixel of a two-dimensional imager has many applications, such as global electronic shuttering or simple image processing. Several solutions are known to realize such a function in the analog domain.

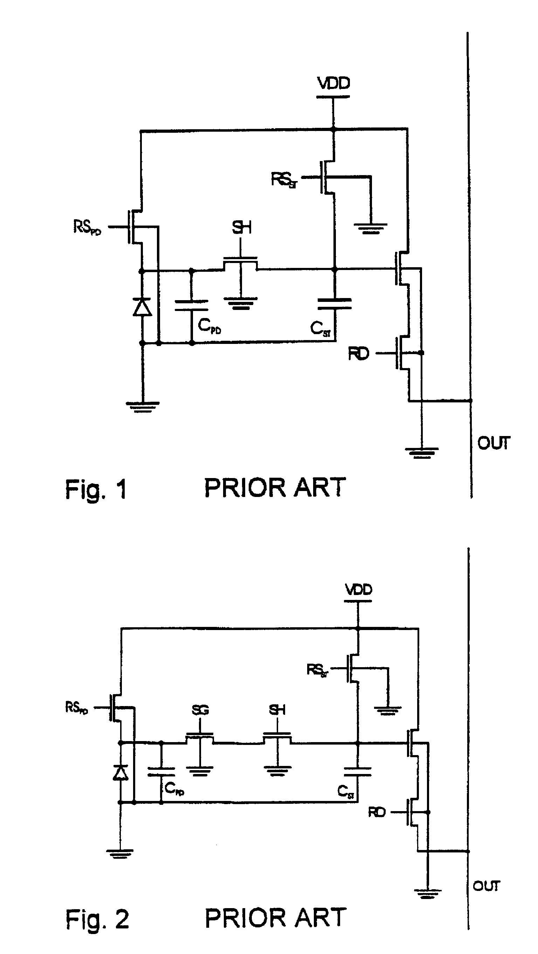

The pixel schematic of a commonly used solution is shown in **Figure 1**. In this pixel an electron-collecting photosensitive element is employed and all in-pixel transistors are of the NMOS type. Disconnecting a readout-node or storage capacitor $C_{ST}$ from the photodiode with the capacitance $C_{PD}$ by means of a shutter transistor SH does the signal storage. The voltage signal $v_s$ available for amplification by the in-pixel amplifier is

$$v_s = q_s/(C_{ST} + C_{PD}), \qquad (1)$$

wherein $q_s$ is the photo-generated charge. As can be seen from this equation, the physically available information $q_s$ is attenuated by the factor $1/(C_{ST} + C_{PD})$. Another disadvantage of this pixel is the insufficient isolation of the storage node with the capacitance $C_{ST}$. It turns out that with the pixel schematic shown in Fig. 1, $C_{ST}$ cannot fully be isolated, because photogenerated electrons will still reach the storage node by diffusion through the semiconductor substrate. This phenomenon is referred to as "parasitic charge integration".

An improved and known version of the pixel of Fig. 1 is shown in Figure 2. In order to decouple the photodiode capacitance $C_{PD}$ from the storage node capacitance $C_{ST}$, a transistor SG is added. By applying a DC voltage to SG, the photo-generated charge $q_s$ is "skimmed" to the readout node capacitance $C_{ST}$ where it generates the voltage swing $v_s$ given by

$$v_s = q_s/C_{ST}. \qquad (2)$$

The voltage swing according to Eq. (2) is larger compared to Eq. (1), because the charge $q_s$ is transferred from $C_{PD}$ to the storage capacitance $C_{ST}$. Nevertheless, the pixel shown in Fig. 2 also suffers from parasitic charge integration on the storage node. Furthermore the additional in-pixel transistor SG reduces the fill factor of the sensor array.

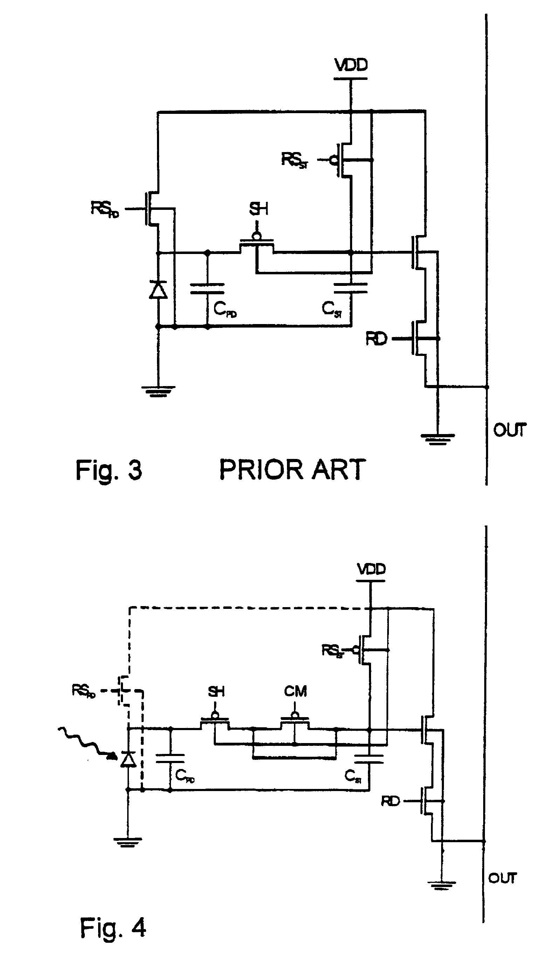

To overcome the problem of parasitic charge integration, the storage node has to be isolated from the substrate in such a way that parasitic charge integration is fully eliminated. This can be accomplished with the pixel structure shown in Figure 3. The storage capacitance $C_{ST}$ is connected by PMOS-type transistors only, which are embedded into an n-well (assuming chip integration on a p-type substrate). This n-well screens the capacitance against parasitic charge contributions. However, in the pixel shown in Fig. 3, the signal is only sampled, creating a signal swing as defined in Eq. (1). Another problem, not mentioned so far, is the nonlinearity introduced by charge injection of the shutter transistor SH.

SUMMARY OF THE INVENTION

The invention aims at providing an active pixel and a method for detecting electromagnetic radiation with an increased sensitivity, avoiding the problems of the prior-art pixels such as described above. More or even all photo-generated charge carriers are transferred onto the storage capacitance which is usually smaller than the capacitance of the photodiode. This is achieved by varying the storage capacitance.

The active pixel with analog storage for a semiconductor-based opto-electronic image sensor according to the invention comprises means for generating an electric photocharge as a function of incident electromagnetic radiation, and means for storing at least part of said photocharge, said storage means having a determined capacitance at a given time and means for varying the capacitance of said storage means by applying an electric signal to said storage means. The opto-electronic image sensor according to the invention comprises a one- or two-dimensional array of pixels, wherein at least one pixel is a pixel according to the invention.

The method for detecting electromagnetic radiation using a pixel according to the invention comprises the steps of generating an electric photocharge as a function of incident electromagnetic radiation, and storing at least part of said photocharge in a storage means, said storage means having a determined capacitance at a given time, whereby the capacitance of said storage means is varied by applying an electric signal to said storage means. Preferably the capacitance of said storage means is set to a first, low value for reading out the photocharge stored in said storage means, and to a second, higher value for storing said photocharge in said storage means.

There is no parasitic charge integration on the storage node of the pixel according to the invention, like for the pixels shown in Figures 1 and 2. But additionally the signal swing is increased up to the maximum possible value of Eq. (2) depending on the mode the pixel is operated in. In the pixel according to the invention, two different modes of operation are foreseen:

(i) In the first mode, the voltage swing is considerably less attenuated than described in Eq. (1), but charge injection from shutter SH still occurs. This mode can be used for realizing a shutter pixel with increased sensitivity.

(ii) In the second mode, the signal charge is completely transferred onto the readout node without introducing parasitic charge integration or nonlinearity problems due to charge injection. This mode can be used for realizing an analog signal storage with increased sensitivity. However, as will be explained, operating the pixel in the second mode is more complex than in the first mode.

BRIEF DESCRIPTION OF THE DRAWINGS

Figure 1      shows a schematic of an active pixel according to the prior art with analog storage.

Figure 2      shows a schematic of an active pixel according to the prior art with analog storage and improved sensitivity.

Figure 3      shows a schematic of an active pixel according to the prior art with analog storage and no parasitic charge integration.

Figure 4      shows a schematic of an active pixel according to the invention.

Figure 5      shows a timing diagram for a first mode of operation of an active pixel according to the invention.

Figure 6      shows potential distributions of an active pixel according to the invention for various steps of a second mode of operation.

Figure 7      shows a timing diagram for the second mode of operation of an active pixel according to the invention.

Figure 8      shows a simplified layout of an active pixel according to the invention.

Figure 9      shows an NMOS-based active pixel according to the invention for dynamic range extension.

Figure 10    shows a known analog subtraction circuit for kTC noise cancellation.

DESCRIPTION OF THE PREFERRED EMBODIMENTS

A schematic of the pixel according to the invention is given in Figure 4. It comprises a photodiode with a capacitance $C_{PD}$ for generating an electric photocharge as a function of incident electromagnetic radiation, and a storage transistor with a capacitance $C_{ST}$. The cathode of the photodiode is connected to a shutter transistor SH. A photodiode reset transistor $RS_{PD}$ is optional and not foreseen in a default configuration. The drain of shutter transistor SH is connected to the source of a modulation transistor CM with a variable capacitance $C_{mod}$. Source and drain of transistor CM are shorted, i.e., transistor CM does not work like a regular analog or digital transistor. Instead, only the MOS-capacitance (MOSCAP) function is used in order to modulate the capacitance of a readout node. An address transistor RD is provided for individually addressing and reading out the pixel. This configuration with a source follower and address transistor RD is one of the simplest schemes to realize an active pixel, but it can be replaced by a more complex amplification/addressing scheme, e.g., in line sensors where space constraints are less stringent. Such a modification is possible for a person skilled in the art and does not affect the basic idea of the invention.

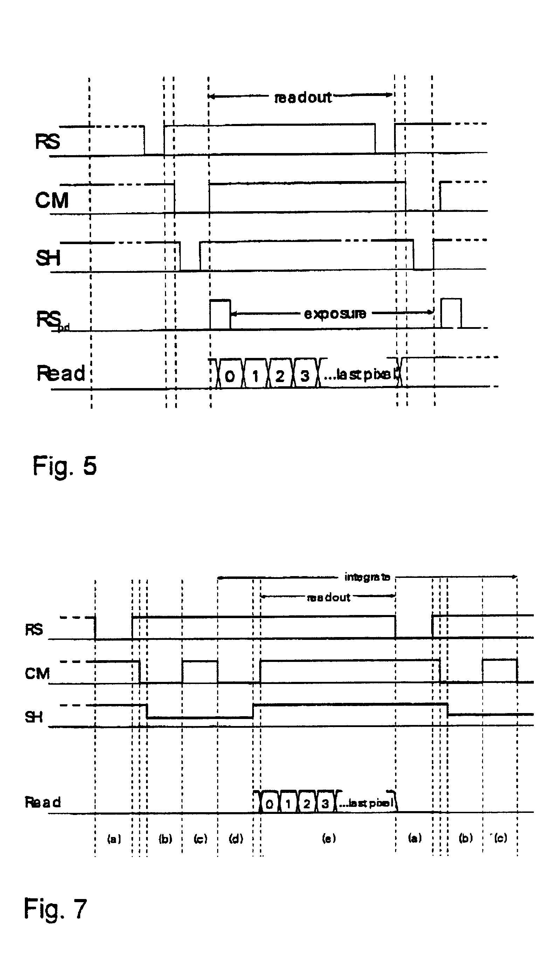

In the <u>first mode</u> of operation the variable or switchable MOSCAP CM improves the charge transfer between photodiode and readout node. The timing diagram including operation of the optional transistor $RS_{PD}$ for this mode is given in Figure 5. The readout sequence starts with resetting the readout node by pulsing RS low. Next, the photo signal is sampled as a voltage onto $C_{ST}$. Therefore a 1-0-1 pulse pattern is applied to CM and SH as shown in Fig. 5. After SH is at its high level again, $C_{PD}$ and $C_{ST}$ are isolated and the photodiode can be reset with $RS_{PD}$ whenever desired in order to set the correct exposure time. Pulsing CM low during the sampling phase increases the effective readout node capacitance to $C_{mod} + C_{ST}$, which results in a more efficient charge transfer. For readout, after SH is back to 1, CM is brought to logic 1 again, in order to minimize the effective readout node capacitance to $C_{ST}$. This increases the voltage swing on the readout node to the value

$$v_{RD} = q_s \left( \frac{1}{C_{ST}} - \frac{C_{PD}}{C_{ST}(C_{PD} + C_{ST} + C_{mod})} \right) \, , \tag{3}$$

where $q_s$ is the photo-generated charge signal and $C_{mod}$ is the maximum capacitance of MOSCAP CM.

It is instructive to consider extreme values of $C_{mod}$. For infinitely large $C_{mod}$, Eq. (3) approaches Eq. (2). For $C_{mod} = 0$, Eq. (3) turns into Eq. (1). For $C_{mod} = C_{PD}$ and $C_{PD} = 10 C_{RD}$, the signal swing is already more than five times larger than without $C_{mod}$.

Because there is no charge skimming involved in this operation mode, the imager based on this pixel does not suffer from image lag.

Operating the pixel in the <u>second mode</u> of operation maximizes the sensitivity. The functionality of this mode is best understood by looking at the potential distribution of the photodiode, the storage node capacitance $C_{ST}$ and the potential modulation introduced by SH and CM. Based on the potential distribution, a hydrostatic equivalent is used to describe the movement of charge carriers, i.e., electrons and holes through the semiconductor. In this mode, transistor $RS_{PD}$ is not used even though it can be implemented to realize a timer function.

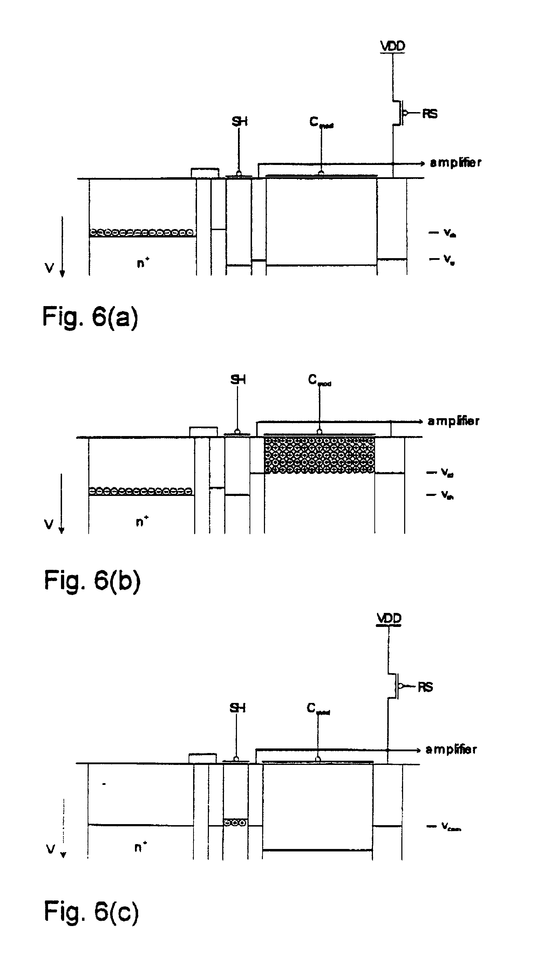

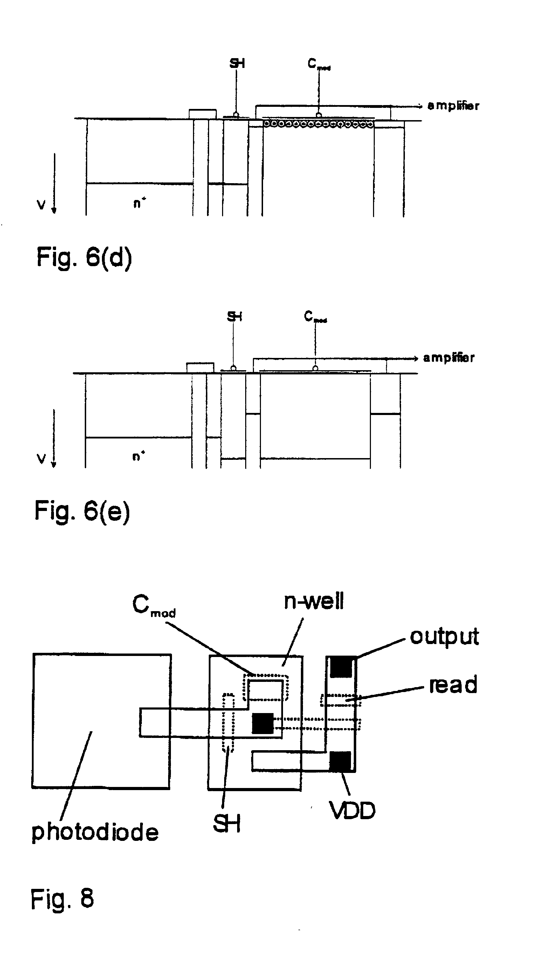

The potential distribution for the various time steps is shown in Figure 6. The description for this second mode of operation starts right after the pixel was reset, as shown in Figure 6(a). The voltage on the readout node is at its reset level $v_{rs}$ and the modulation capacitance $C_{mod}$ is 0. The photodiode is continuously integrating and photo-generated charge carriers are accumulating as indicated. SH and CM are both biased to a logic high level.

In a second step, Figure 6(b), the pixel is prepared to transfer photo-generated electrons from the photodiode to the readout node. Therefore CM is pulsed to logic 0 to decrease the readout node voltage $v_{RD}$ below $v_{SH}$, the potential level established inside the semiconductor by gate SH. This potential barrier $v_{SH}$ is set by pulsing SH to a corresponding analog level. So far no charge has been exchanged between photodiode and readout node.

In a third step shown in Figure 6(c), CM is pulsed back to logic 1 and positive charge carriers, i.e., holes, are "pushed" across the potential barrier where they are compensated with electrons. There is one common potential $v_{com}$ established across photodiode and readout node.

In the next moment, CM is pulsed back to logic 0, as shown in Figure 6(d). In this step, holes are skimmed across the potential barrier. The amount of charges transferred to the readout node corresponds exactly to the number of photo-generated electrons because the default level of the photodiode before illumination is established again. The voltage swing on the readout node is, however, fairly small, because of the additional capacitance $C_{mod}$.

In the last step of the readout cycle, Figure 6(e), the voltage swing on the readout node is increased again. Therefore, first SH and afterwards $C_{mod}$ is pulsed to logic 1. The whole signal charge $q_s$ is now on the readout node capacitance $C_{RD}$ where it causes a voltage change $q_s/C_{RD}$.

The timing diagram for this readout sequence is given in Figure 7. The pixel is at all times light sensitive, i. e., there is no interruption of charge-carrier integration during a photodiode reset or any other clock interval. In that way, the maximum possible integration time is achieved.

To further illustrate the functionality of the pixel according to the invention, the amount of charge and the voltage level is calculated for the different time steps. The results are given in Table I.

Table I

| Time step | Potential | Charge | Other |
|---|---|---|---|
| (a) | $v_{RD}^{(a)} = v_{RS}$ | $q_{RS} = v_{RS}C_{RD}$ | $v_{SH}^{(a)} \geq v_{RS}$ |
| (b) | $v_{RD}^{(b)} = \dfrac{Q_{RS}}{C_{RD} + C_{mod}}$ | | $v_{RD}^{(b)} \leq v_{SH}^{(b)}$ |
| (c) | $v_{com}^{(c)} = \dfrac{Q_{RS}\text{-}Q_s}{C_{RD} + C_{mod} + C_{PD}}$ | | |
| (d) | $v_{RD}^{(d)} = \dfrac{Q_{RS}\text{-}Q_s}{C_{RD} + C_{mod}}$ | | $q_s \leq (v_{RS} - v_{SH}^{(b)}) \cdot C_{RD}$ <br><br> $v_{RD}^{(d)} \leq v_{SH}^{(b)}$ |
| (e) | $v_{RD}^{(e)} = v_{RS}^{(a)}\text{-}\dfrac{Q_S}{C_{RD}}$ | $q_{RD} = q_{RS} - q_s$ | $\Delta v_{RD}^{max} = v_{RS}\text{-}v_{SH}^{(b)}$ |

From Table I some guidelines can be given for a proper sizing of $C_{mod}$ in order to optimize the output voltage swing $\Delta v_{RD}^{max}$. Using the relation $v_{RD}^{(b)} \leq v_{SH}^{(b)}$, the results listed in Table II are calculated.

Table II

| $\Delta v^{max}{}_{RD}$ [V] | $v_{rs}$ [V] | $v_{sh}$ [V] | $C_{mod}/C_{RD}$ |
|---|---|---|---|
| 0.5 | 3.3 | 2.8 | 0.18 |
| 1.0 | 3.3 | 2.3 | 0.43 |
| 1.5 | 3.3 | 1.8 | 0.82 |
| 1.65 | 3.3 | 1.65 | 1.0 |
| 2.0 | 3.3 | 1.3 | 1.5 |
| 2.5 | 3.3 | 0.8 | 1.86 |

Furthermore the photodiode capacitance $C_{PD}$ has to be chosen large enough, so that the maximum voltage swing $v_s$ which the charge $q_s$ can generate on $C_{PD}$ during the longest integration time is small enough, i.e.,

$$v_s = \frac{Q_s}{C_{PD}} \leq v_{SH}^{(b)}. \tag{4}$$

Implementation of the capacitance modulation can be realized in standard CMOS technology using a MOSCAP. Such a MOSCAP is very small due to the large area capacitance of the poly-gate-oxide-channel implant capacitor structure. Figure 8 shows a simplified layout of such a pixel structure.

The principle of readout node charge modulation can also be applied to extend the dynamic range of a conventional pixel. If the overall noise is dominated by kTC$_{RS}$ noise, the dynamic range DR of the pixel scales with $\sqrt{C_{RS}}$, where $C_{RS}$ is the total capacitance of the readout node including the photodiode:

$$DR = \frac{\Delta U_{max}\sqrt{C_{RS}}}{\sqrt{kT}}. \qquad (5)$$

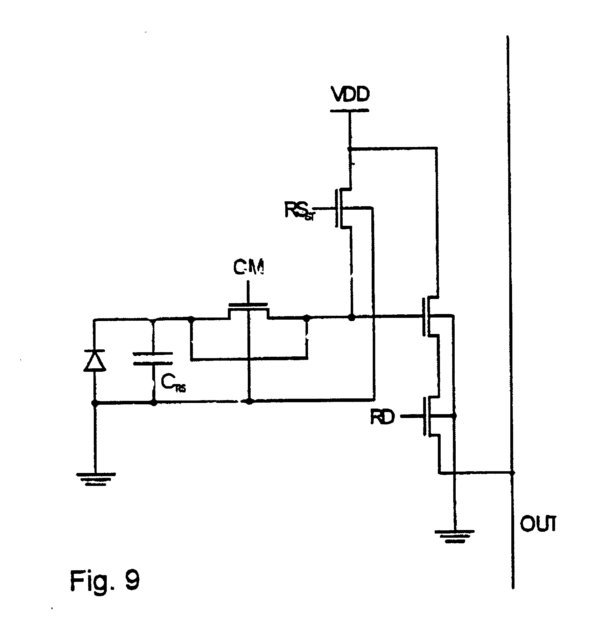

Using an NMOS-based MOS capacitor, a classical active pixel can be modified to the pixel shown in Figure 9. Compared to Eq. (5), the dynamic range of this pixel is

$$DR = \frac{\Delta U_{max}\sqrt{C_{RS}}}{\sqrt{kT}}\left(1 + \frac{C_{mod}}{C_{RS}}\right). \qquad (6)$$

To illustrate Eq. (6), a capacitance $C_{mod} = 9C_{RS}$ is considered. In the kTC-noise-limited case the dynamic range extension is 20 dB.

The analog storage of the pixel according to the invention can also be used to store the reset value of the readout node before exposure. Due to the charge transport mechanism according to the invention, the photo-generated charge can be transferred to the readout node without distorting the initial condition from before the exposure. This offers the possibility to eliminate kTC noise, the dominating noise source in most of today's active-pixel sensors. Therefore, an analog subtraction circuit as it is, e.g., used for fixed pattern noise cancellation, has to be implemented to execute true correlated double sampling (CDS). While the term CDS has erroneously also been used for fixed pattern noise cancellation, kTC noise can only be eliminated if the default value of the readout node can be sampled first and then the signal charge is added to the readout node without adding noise, which has become possible with the pixel according to the present invention.

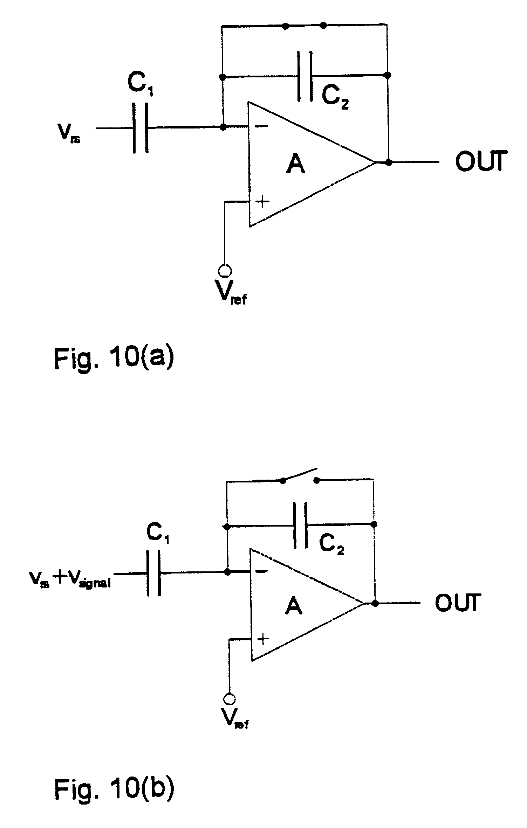

The schematic for a known analog subtraction circuit based on switched capacitors is given in Figure 10. Such a circuit can be implemented columnwise at the output of the pixel according to the invention, e.g., the pixel of Fig. 9. In the step shown in Figure 10(a), the reset voltage $v_{RS}$ is sampled onto $C_1$. In the step shown in Figure 10(b), the voltage $v_{RS} + v_s$ is subtracted, thus yielding the difference signal $v_{RS} - (v_{RS} + v_s) = -v_s$ which is free of kTC noise.

The functionality of the circuit is explained in the equations listed in Table III by applying charge conservation rules to the capacitor connecting node.

Table III

| Step (a) | Step (b) |
|---|---|
| $-q^{(a)}_1 = (v_{RS} - v_{ref})C_1$ | $-q^{(b)}_1 = (v_{RS} + v_s - v_{ref})C_1$ |
| $q^{(a)}_2 = 0$ | $q^{(b)}_2 = (v_{ref} - v_{out})C_2$ |
| Charge conservation:<br><br>$-q^{(a)}_1 + q^{(a)}_2 = -q^{(b)}_1 + q^{(b)}_2$ | |
| Therefore:<br><br>$v_{out} = v_s\dfrac{C_1}{C_2} + v_{ref}C_2$ | |

In the equations of Table III, $v_{ref}C_2$ is the black-level reference that can be adjusted to a desired value. In particular, this reference can be made zero.

**Claims**

**1.** An active pixel with analog storage for a semiconductor-based opto-electronic radiation sensor, comprising:

means for generating an electric photocharge as a function of incident electromagnetic radiation, and

means for storing at least part of said photocharge, said storage means having a determined capacitance at a given time,

**characterized by**
means for varying the capacitance of said storage means by applying an electric signal to said storage means.

2. The pixel according to claim 1, wherein said pixel is manufactured in CMOS technology and said variation means comprise a MOS capacitance.

3. The pixel according to claim 2, wherein said variation means comprise a plurality of individually addressable MOS capacitances arranged in parallel.

4. The pixel according to one of the claims 1-3, additionally comprising means, e.g. a transistor (preferably a field-effect-transistor), for disconnecting said photocharge-generating means from said storage means.

5. The pixel according to one of the claims 1 to 4, wherein said generated photocharge is of a first polarity type and said stored photocharge is of a second polarity charge.

6. The pixel according to one of the claims 1-5, additionally comprising means, e.g. a transistor (preferably a field-effect-transistor), for resetting said storage means, and/or means, e.g. a transistor (preferably a field-effect-transistor), for resetting said photocharge-generating means.

7. The pixel according to one of the claims 1-6, wherein said photocharge-generating means comprise a photosensitive element.

8. The pixel according to one of the claims 1-7, additionally comprising an analog subtraction circuit for noise reduction, preferably based on switched capacitors.

9. An opto-electronic image sensor with a one- or two-dimensional array of pixels, said array comprising at least one pixel according to one of the claims 1-8.

10. The image sensor according to claim 9, additionally comprising means for individually addressing a pixel or a group of pixels.

11. A method for detecting electromagnetic radiation using the pixel according to one of the claims 1-8, comprising the steps of:

   generating an electric photocharge as a function of incident electromagnetic radiation, and

   storing at least part of said photocharge in a storage means, said storage means having a determined capacitance at a given time,

   **characterized in that**
   the capacitance of said storage means is varied by applying an electric signal to said storage means.

12. The method according to claim 11, wherein the capacitance of said storage means is set to a first low value for reading out the photocharge stored in said storage means, and to a second higher value for storing said photocharge in said storage means.

13. The method according to claim 12, comprising the steps of:

   generating an electric photocharge as a function of incident electromagnetic radiation,

   resetting said storage means,

   setting the capacitance of said storage means to a first low value,

   storing at least part of said photocharge in said storage means,

increasing the storage capacitance to a second higher value during the step of storing said photocharge in said storage means,

resetting the capacitance of said storage means to the first low value, and

reading out the photocharge stored in said storage means.

14. The method according to claim 12, comprising the steps of:

generating an electric photocharge as a function of incident electromagnetic radiation,

resetting said storage means,

setting the capacitance of said storage means to a first low value,

storing at least part of said photocharge in said storage means,

disconnecting said storage means by means of a transistor,

increasing the storage capacitance to a second higher value during the step of storing said photocharge in said storage means,

resetting the capacitance of said storage means to the first low value, and

reading out the photocharge stored in said storage means.

15. The method according to claim 14, comprising the steps of:

generating an electric photocharge as a function of incident electromagnetic radiation,

resetting said storage means,

setting the capacitance of said storage means to a first low value,

increasing the storage capacitance to a second higher value,

setting a potential barrier between said photocharge generating means and said storage means by applying an analog voltage to the gate of said transistor for disconnecting,

resetting the capacitance of said storage means to the first low value,

increasing the storage capacitance to the second higher value, thus storing a charge corresponding to said photocharge in said storage means,

disconnecting the photocharge generating means from the storage means by applying the appropriate logic level to said disconnecting transistor,

resetting the capacitance of said storage means to the first low value, and

reading out the charge stored in said storage means.

16. The method according to one of the claims 11-15, wherein a first electric signal is read out from said storage means after resetting said storage means, a second electric signal is read out from said storage means after storing at least part of said photocharge in said storage means, and a subtraction of said first and said second electric signal is performed.

17. Use of the method according to claim 13 for realizing a shutter pixel with increased sensitivity.

**18.** Use of the method according to claim 14 for realizing an analog signal storage with increased sensitivity.

**19.** Use of the method according to claim 13 for realizing a radiation sensor with increased dynamic range.

Fig. 1    PRIOR ART

Fig. 2    PRIOR ART

VDD

RS_ST

RS_PD

SH

C_PD

C_ST

RD

OUT

## Fig. 3 PRIOR ART

VDD

RS_ST

RS_PD

SH

CM

C_PD

C_ST

RD

OUT

## Fig. 4

Fig. 5

Fig. 7

Fig. 6(a)

Fig. 6(b)

Fig. 6(c)

Fig. 6(d)

Fig. 6(e)

Fig. 8

Fig. 9

Fig. 10(a)

Fig. 10(b)

**European Patent Office**

**EUROPEAN SEARCH REPORT**

Application Number

EP 01 81 0136

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 99 66560 A (FOVEON INC) 23 December 1999 (1999-12-23) * figures 5,6,8 * * page 9, line 24 - page 12, line 20 * * page 15, line 29 - page 16, line 9 * | 1-7, 9-13,18, 19 | H01L27/146 H04N3/15 |
| Y | | 8,14-16 | |
| Y | WO 00 05874 A (FOVEON INC) 3 February 2000 (2000-02-03) * figures 10,11 * * page 1 - page 2 * * page 8, line 33 - page 10, line 2 * * page 13, line 3 - line 26 * | 8,14-16 | |
| X | PATENT ABSTRACTS OF JAPAN vol. 1995, no. 09, 31 October 1995 (1995-10-31) -& JP 07 142692 A (CANON INC), 2 June 1995 (1995-06-02) * abstract * | 1,2,4,6, 7,9-11 | |
| X | US 5 742 058 A (PANTIGNY PHILIPPE ET AL) 21 April 1998 (1998-04-21) * figures 2A,2B,9B * * column 3, line 12 - column 4, line 34 * * column 19, line 13 - line 18 * | 1,2,4-7, 9,10 | TECHNICAL FIELDS SEARCHED (Int.Cl.7) H01L H04N |
| A | US 6 078 037 A (BOOTH JR LAWRENCE A) 20 June 2000 (2000-06-20) * the whole document * | 1,9,11 | |

The present search report has been drawn up for all claims

| Place of search | Date of completion of the search | Examiner |
|---|---|---|
| THE HAGUE | 13 July 2001 | Visscher, E |

EPO FORM 1503 03.82 (P04C01)

**ANNEX TO THE EUROPEAN SEARCH REPORT
ON EUROPEAN PATENT APPLICATION NO.**

EP 01 81 0136

This annex lists the patent family members relating to the patent documents cited in the above-mentioned European search report.
The members are as contained in the European Patent Office EDP file on
The European Patent Office is in no way liable for these particulars which are merely given for the purpose of information.

13-07-2001

| Patent document cited in search report | | Publication date | Patent family member(s) | | Publication date |
|---|---|---|---|---|---|
| WO 9966560 | A | 23-12-1999 | NONE | | |
| WO 0005874 | A | 03-02-2000 | NONE | | |
| JP 07142692 | A | 02-06-1995 | NONE | | |
| US 5742058 | A | 21-04-1998 | FR | 2735632 A | 20-12-1996 |
| | | | DE | 69606098 D | 17-02-2000 |
| | | | DE | 69606098 T | 31-08-2000 |
| | | | EP | 0749233 A | 18-12-1996 |
| US 6078037 | A | 20-06-2000 | AU | 2978799 A | 08-11-1999 |
| | | | EP | 1078390 A | 28-02-2001 |
| | | | TW | 421957 B | 11-02-2001 |
| | | | WO | 9954912 A | 28-10-1999 |

EPO FORM P0459

For more details about this annex : see Official Journal of the European Patent Office, No. 12/82